# EUROPEAN PATENT APPLICATION

(11) **EP 4 845 377 A1**
(43) Date of publication of application: **25.11.2026**
(21) Application number: 26179452.3
(22) Date of filing: 19.05.2026
(51) Int. Cl.: H10W 40/25, H10W 40/00, H10W 40/20, H10W 40/22, H10W 40/47

(54) **A HIGH THERMAL CONDUCTIVITY COLD PLATE WITH FINS FOR A SEMICONDUCTOR, OPTICAL, ELECTRONIC, OR QUANTUM COMPUTING DEVICE**

(30) Priority: 21.05.2025 US 202563809551 P; 14.05.2026 US 202619677046
(71) Applicant: II-VI Delaware, Inc., Wilmington, DE 19890 (US)
(72) Inventor: Murano, Robert, Wilmington, 19890 (US); Patkar, Shailesh, Wilmington, 19890 (US); Tanner, Charles D., Wilmington, 19890 (US); Rehberg, Eric, Wilmington, 19890 (US); Aghajanian, Michael K., Wilmington, 19890 (US); Chen, Young-Kai, Wilmington, 19890 (US); Rummel, Steve, Wilmington, 19890 (US); Xu, Wen-Qing, Wilmington, 19890 (US); Thompson, Alan, Wilmington, 19890 (US); Toy, Cetin, Wilmington, 19890 (US); Coppola, Jonathan, Wilmington, 19890 (US)
(74) Representative: Bosch Jehle Patentanwaltsgesellschaft mbH

(57) **Abstract**

A cold plate includes a base plate and fins. The base plate includes a top side, a bottom side, and lateral sides between the bottom side and the top side. The fins protrude from the top side of the base plate. The base plate and/or the fins have a thermal conductivity greater than about 450 W/m-K.

## Description

### CROSS-REFERENCE TO RELATED APPLICATIONS AND INCORPORATION BY REFERENCE

The present application claims the benefit of and priority to U.S. Provisional Application 63/809,551, filed May 21, 2025, the disclosure of which is hereby incorporated herein by reference in its entirety.

### TECHNICAL FIELD

Aspects of the present disclosure relate to cold plates and manufacturing of cold plates.

### BACKGROUND

Modern semiconductor devices due to device densities and/or operating frequencies may produce large amounts of heat. As such, thermal management devices and thermal management materials are needed to maintain peak operating efficiency of such semiconductor devices.

Further limitations and disadvantages of conventional and traditional approaches will become apparent to one of skill in the art, through comparison of such approaches with some aspects of the present disclosure as set forth in the remainder of the present application with reference to the drawings.

### BRIEF SUMMARY OF THE DISCLOSURE

Shown in and/or described in connection with at least one of the figures, and set forth more completely in the claims, are cold plates and methods of manufacturing cold plates.

Advantages, aspects, and novel features of such cold plates, uses of such cold plates, and methods of manufacturing such cold plates, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1 provides a perspective view of a cold plate in accordance with aspects of the present disclosure.
FIG. 2 depicts a cooling system for a heat-generating device, which includes the cold plate of FIG. 1.
FIGS. 3A-3C depict general methods for manufacturing the cold plate of FIG. 1.
FIG. 4 depicts aspects of a laser ablation method of manufacturing the cold plate of FIG. 1.
FIG. 5 depicts a method of manufacturing the cold plate of FIG. 1 by mold casting fins and subsequently providing a high thermal conductivity base plate on such fins.
FIGS. 6A-6C depict a method of manufacturing the cold plate of FIG. 1 by growing a diamond base plate and then mold cast fins on the diamond base plate.
FIGS. 7A and 7B depict a method of manufacturing the cold plate of FIG. 1 by providing diamond fins on a base plate of high thermal conductivity material (e.g., diamond-SiC or diamond-SiC-Si composite).
FIGS. 8A-8C depict a method of manufacturing the cold plate of FIG. 1 using a diamond base plate with bonded diamond fins.
FIGS. 9A-9B depict a method of manufacturing the cold plate of FIG. 1 in which a diamond base plate is grown on diamond fins.
FIG. 10 depicts a method of manufacturing the cold plate of FIG. 1 with a diamond base plate and copper or copper diamond fins.
FIG. 11 depicts a method of manufacturing the cold plate of FIG. 1 with a diamond-SiC or diamond-SiC-Si composite base plate and copper or copper diamond fins.

### DESCRIPTION

Aspects of the present disclosure are directed to cold plates and methods of manufacturing cold plates.

The figures illustrate a general manner of construction. Descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A may be directly contacting element B or indirectly connected to element B by an intervening element C. Similarly, the terms "over" or "on" may be used to describe two elements directly contacting each other or describe two elements indirectly connected by one or more other elements.

Also, any numerical range recited herein is intended to include all sub-ranges subsumed therein. For example, a range of "1 to 10" is intended to include any and all sub-ranges between and including the recited minimum value of 1 and the recited maximum value of 10, that is, all sub-ranges beginning with a minimum value equal to or greater than 1 and ending with a maximum value equal to or less than 10, and all sub-ranges in-between, e.g., 1 to 6.3, or 5.5 to 10, or 2.7 to 6.1. Moreover, as used herein the term "about" when referring to numerical values corresponds to values within 5% of the stated numerical value in order to account for manufacturing and/or other variances.

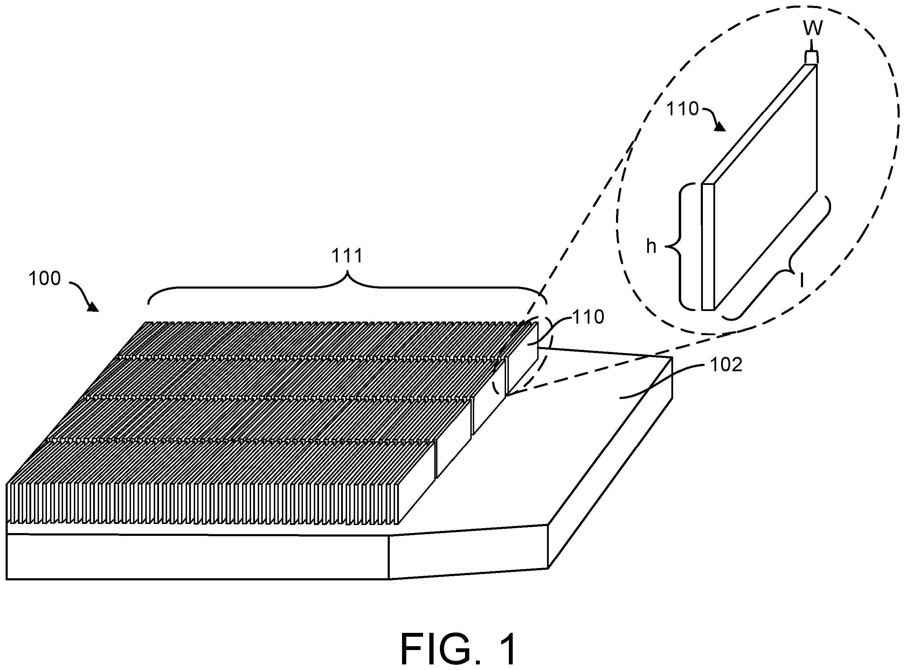

Referring now to FIG. 1, an example cold plate 100 is shown in accordance with aspects of the present disclosure. The cold plate 100 may comprise a base plate 102 having a top side, a bottom side, and lateral sides between the top side and the bottom side. The bottom side of the base plate 102 may include a recess sized to accommodate a semiconductor package or other electrical component. In this manner, the recess of the cold plate 100 may receive and surround a semiconductor package or other heat generating component to which the cold plate 100 is mounted.

The cold plate 100 may further comprise fins 110 that protrude above the top side of the base plate 102. The fins 110 may effectively increase the external surface area of the cold plate 100 and thus may increase the cooling or thermal transfer efficiency of the cold plate 100. In particular, the fins 110 may aid in transferring heat to a fluid or coolant that is in contact with the fins 110 of the cold plate 100. Such fluid or coolant may include, for example, distilled/deionized (DI) water or a glycol water mixture with corrosion inhibitors, dielectric fluids (*e.g.,* polyalphaolefin), air, helium, and/or other liquids and/or gases that flow between, over, and/or around the fins 110 and/or otherwise interact with surfaces of the cold plate 100.As shown, the fins 110 may be arranged along the top side of the base plate 102 in rows and columns. In particular, each fin 110 may protrude from the top side of the base plate 102 at a right angle. However, in other embodiments, the fins 110 may protrude from the top side of the base plate 102 at other or additional angles. Furthermore, in some embodiments, the angle at which the fins 110 protrude from the top side of the base plate 102 may vary among the fins 110. In yet further embodiments, other surfaces of the base plate 102, such as one or more of the lateral sides, may also include fins 110.

Moreover, the fins 110 may be arranged in a fin array 111 comprising a quantity of rows *m* that each have quantity of columns *n*. For example, the quantity of rows m may be greater than about 10, greater than about 40, greater than about 80, greater than about 120, or greater than about 160. Similarly, the quantity of columns *n* may be greater than about 1, greater than about 2, greater than about 4, greater than about 6, or greater than about 10. Moreover, the fin array 111 may comprise greater than about 10 fins 110, greater than about 40 fins 110, greater than about 100 fins 110, greater than about 200 fins 110, greater than about 300 fins 110. While each row *m* may have the same number of fins 110, in some embodiments the quantity *n* of fins 110 in each row *m* may vary. Moreover, the fins 110 of a respective row and/or column may not all be the same. Furthermore, the fins 110, in some embodiments, may be placed in a disordered manner (*i.e.,* not in orderly rows and/or columns).

In various embodiments, each fin 110 may have an aspect ratio (height *h* / width *w*) of greater than about 1, greater than about 1.5, greater than about 2, greater than about 4, greater than about 5, or greater than about 10. Moreover, each fin 110 may have a minimum feature size (*e.g*., fin width w and/or trench width *tw*) of less than about 100 µm, less than about 200 µm, less than about 300 µm, less than about 400 µm, or less than 500 µm. The fins 110 may also take various shapes. For example, the fins 110 may be rectangular, circular, square, spiral, or irregular in shape.

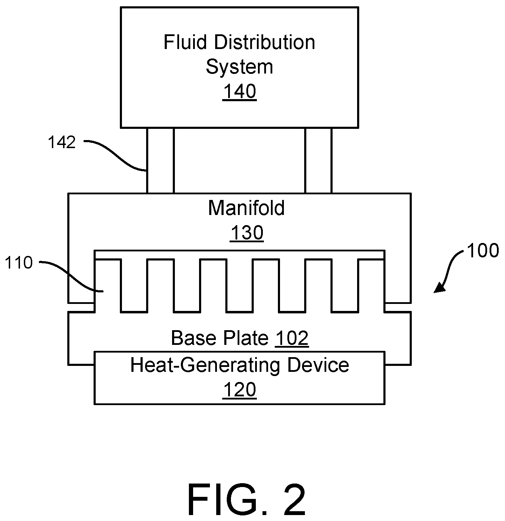

As shown in FIG. 2, a cooling system 101 for a heating-generating device 120 may include the cold plate 100 of FIG. 1, a manifold 130, and fluid distribution system 140. In particular, the bottom side of the cold plate 100 may be mounted to the heat-generating device 120. The heat-generating device 120 may include a graphics processing unit (GPU), a tensor processing unit (TPU), a central processing unit (CPU), optical component, electrical component, a quantum computing component, *etc,* Moreover, the manifold 130 may couple the fluid distribution system 140 to the top side of the cold plate 100 via two or more fluid-carrying conduits 142. In various embodiments, the fluid distribution system 140 via the manifold 130 and conduits 142 may circulate fluid (*e.g*., gas or liquid) through the fins 110 and trenches 112 of the cold plate 100 so as to transfer thermal energy from the heat-generating device 120 to the fluid distribution system 140 via the cold plate 100.

In some embodiments, the base plate 102 may be mounted to the heat-generating device 120 via a thermal interface material, such as a paste, a phase change medium, and/or thermal conductive liquid (*e.g.,* a liquid metal). In such embodiments, the base plate 102 may be further secured to the heat-generating device 120 via a clamping mechanism. In other embodiments, the base plate 102 may be mounted to the heat-generating device 120 by an adhesive, such as an organic or inorganic glue, in which an O-ring or recess of the base plate 102 is filled or unfilled with a filler material. In further embodiments, the base plate 102 may be directly bonded to the heat-generating device 120 via a bonding process that involves surface activation. In yet other embodiments, the base plate 102 may be mounted to the heat-generating device 120 by soldering or brazing the bottom side of the base plate 102 to the heat-generating device 120, In such embodiments, the bottom side of the base plate 102 may be metalized to provide an adhesion layer. Such adhesion layer may comprise a carbide forming element of Group IVA (such as Si and Ge), Group IVB (such as Ti, Zr, and Hf), Group VB (V, Nb, and Ta), and Group VIB (such as Cr, Mo, and W). Moreover, such adhesion layer may include a barrier layer comprising a metallic element, an insulating element, and/or a semiconducting element.

Similarly, the manifold 130 may be mounted to the cold plate 120 via various manners. In some embodiments, the manifold 130 may be mounted to the cold plate 100 via a thermal interface material, such as a paste, a phase change medium, and/or thermal conductive liquid (*e.g.,* a liquid metal). In such embodiments, the manifold 130 may be further secured to the cold plate 100 via a clamping mechanism. In other embodiments, the manifold 130 may be mounted to the cold plate 100 by an adhesive, such as an organic or inorganic glue. In some embodiments, the manifold 130 may be secured to a top side of the base plate 102 via an O-Ring. In such embodiments, the manifold 130 may be further secured to the cold plate 100 via a clamping mechanism.

In further embodiments, the manifold 130 may be directly bonded to the cold plate 100 via a bonding process that involves surface activation. In various embodiments, the manifold 130 may be mounted to the cold plate 100 via soldering or brazing. In such embodiments, one or more surfaces of the base plate 102 and/or fins 110 may be metalized with an adhesion layer. Such adhesion layer may comprise a carbide forming element of Group IVA (such as Si and Ge), Group IVB (such as Ti, Zr, and Hf), Group VB (V, Nb, and Ta), and Group VIB (such as Cr, Mo, and W). Moreover, such adhesion layer may include a barrier layer comprising a metallic element, an insulating element, and/or a semiconducting element.

In various embodiment, the manifold 130 may comprise one or more metallic materials, ceramic materials, polymer materials, insulating materials, conductive materials, low thermal conductivity materials, and/or a high thermal conductivity materials. In some embodiments, the manifold 130 may comprise aluminum, copper, stainless steel, nickel-cobalt ferrous alloy (*e.g*., Kovar), tungsten, molybdenum, silicon, ceramics, glass, quartz, or nickel-iron alloy (*e.g*., Invar). Moreover, the manifold 130 may have a CTE that closely matches the cold plate 100. For example, an absolute value of coefficient of thermal expansion (CTE) difference between the manifold 130 and the cold plate 100 (ΔCTE) may be less than 25 ppm/m-K, less than 17 ppm/m-K, less than 10 ppm/m-K, less than 6 ppm/m-K, less than 4 ppm/m-K, or less than 2 ppm/m-K.

As explained in greater detail below, the base plate 102 and/or the fins 110 may be constructed using various high thermal conductivity materials. In some embodiments, the base plate 102 and the fins 110 may be constructed from the same high thermal conductivity material. In other embodiments, the base plate 102 may be constructed from a high thermal conductivity material that differs from the high thermal conductivity material used to construct the fins 110.

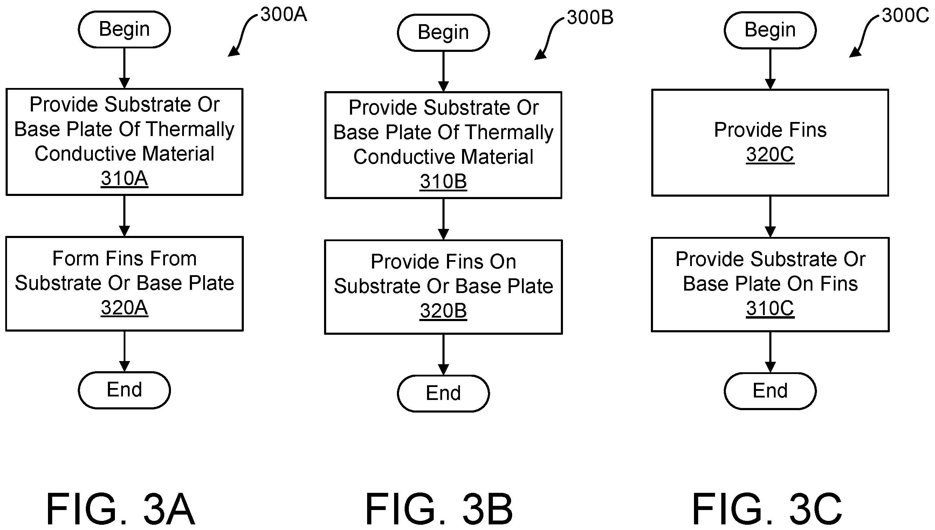

In addition to being constructed from various high thermal conductivity materials, the cold plate 100 may also be constructed via several different methods. For example, FIGS. 3A-3C depict general methods of forming the cold plate 100. In particular, each method 300A, 300B, 300C may include providing a high thermal conductivity substrate 102' or base plate 102 at 310A, 310B, 310C. In some embodiments, the high thermal conductivity substrate 102' or base plate 102 may be formed via molding, casting, deposition, and/or other means. Moreover, the high thermal conductivity substrate 102' or base plate 102 may be further attached to a carrier to ease handling of the high thermal conductivity substrate 102' during formation of the cold plate 100. In other embodiments, instead of being formed at 310A, 310B, 310C, the high thermal conductivity substrate 102' or base plate 102 may be sourced or otherwise acquired. In such embodiments, the high thermal conductivity substrate 102' may be cut to size and attached to a carrier at 310A, 310B, 310C to ease further processing of the cold plate 100.

Furthermore, each method 300A, 300B, 300C may include forming fins 110 at 320A, 320B, 320C. In some embodiments, after providing the high thermal conductivity substrate 102', the fins 110 of the cold plate 100 may be formed from and/or attached to the high thermal conductivity substrate 102'. See, *e.g*., FIGS. 3A and 3B. In other embodiments, the fins 110 may be formed first at 320C and then the high thermal conductivity substrate 102' or base plate 102 may be formed on or attached to the fins 110 at 310C. See, *e.g*., FIG. 3C.

For example, as shown in FIG. 3A, high thermal conductivity material may be removed from the high thermal conductivity substrate 102' at 320A. In this manner, the base plate 102 and the fins 110 of the cold plate 100 may be formed from a same high thermal conductivity substrate 102'. As such, the base plate 102 and the fins 110 may be integrated and formed from the same high thermal conductivity material.

In other embodiments, as shown in FIG. 3B, the fins 110 may be formed and/or otherwise attached to one or more surfaces of the high thermal conductivity substrate 102' or base plate 102 at 320B. Alternatively, as shown in FIG. 3C, the high thermal conductivity substrate 102' or base plate 102 may be formed and/or otherwise attached to the fins 110 at 310C. In such embodiments, the base plate 102 and the fins 110 may be formed from different high thermal conductivity materials or may be formed from the same high thermal conductivity material.

The methods of FIGS. 3A and 3B, as well as the cold plate 100, may be implemented in various different manners as explained in greater detail below. But, in general, the high thermal conductivity substrate 102', the base plate 102, and/or the fins 110 of the cold plate 100 are formed from various high thermally conductive materials that provide properties that are conducive to cooling.

In particular, the high thermal conductivity substrate 102', the base plate 102, and/or the fins 110 may comprise a metallic matrix of copper (Cu), aluminum (Al), nickel (Ni), tungsten (W), molybdenum (Mo), titanium (Ti), tantalum (Ta), and/or chromium (Cr); a ceramic matrix of silicon carbide (SiC), tungsten carbide (WC), molybdenum carbide (MoC), and/or boron nitride (BN); or a semiconductor matrix of silicon (Si) and/or germanium (Ge). In some embodiments, the high thermal conductivity substrate 102' may comprise a single crystal, a polycrystalline, or a composite of diamond and/or boron nitride having interfaces of nitride and/or carbide species including silicon carbide (SiC), tungsten carbide (WC), molybdenum carbide (MoC), chromium carbide (CrC), zirconium carbide (ZrC), tantalum carbide (TaC), hafnium carbide (HfC), vanadium carbide (VC), niobium carbide (NbC), and/or germanium carbide (GeC).

In some embodiments, the high thermal conductivity substrate 102', the base plate 102, and/or the fins 110 may be formed from a diamond-silicon carbide composite material or a diamond-silicon carbide-silicon composite material (*i.e.,* a diamond-SiC or diamond-SiC-Si composite material). In particular, grade 550, 700, and/or 800 Thermadite^{™} material from Coherent Corp. may provide a suitable diamond-SiC-Si composite material for the high thermal conductivity substrate 102'. Properties of grade 550, 700, and 800 Thermadite^{™} materials are summarized in the following Table 1.

**Table 1**

| Material Property | Test Temperature | Grade 550 | Grade 700 | Grade 800 |
|---|---|---|---|---|
| Nominal Diamond Content (vol. %) | - | 55 | 60 | 65 |
| Nominal Diamond Grain Size (micron) | - | 65 | 65 | 65 |
| Density (g/cc) | 20°C | 3.34 | 3.38 | 3.40 |
| Young's Modulus (GPa) | 20°C | 750 | 800 | 820 |
| Poisson's Ratio | 20°C | 0.14 | 0.16 | 0.17 |
| Flexural Strength (MPa) | 20°C | 250 | 250 | 250 |
| Hardness (kg/mm²) | 20°C | > 3000 | > 3000 | > 3000 |
| Coefficient of Th. Exp.(ppm/K) | 20-100°C | 1.6 | 1.5 | 1.4 |
| Specific Heat (J/kg-K) | 20°C | 700 | 660 | 640 |
| Thermal Conductivity (W/m-K) | 20°C | 550 | 700 | 800 |

As a result of being formed from one or more of the above-noted high thermal conductivity materials, the high thermal conductivity substrate 102', the fins 110, and/or the cold plate 100 in various embodiments may possess a thermal conductivity that is greater than the thermal conductivity of copper, which is about 400 W/m-K. In particular, as used herein, a high thermal conductivity material or substrates 102', base plates 102, fins 110, and/or the cold plates 100 formed therefrom have a thermal conductivity greater than about 450 W/m-K, and thus a thermal conductivity higher than copper. However, in some embodiments, the high thermal conductivity materials used to form the cold plate 100 may have even higher thermal conductivities such as thermal conductivities greater than about 500 W/m-K, greater than about 550 W/m-K, greater than about 600 W/m-K, greater than about 650 W/m-K, greater than about 700 W/m-K, greater than about 750, or greater than about 800 W/m-K. In various embodiments, the thermal conductivity of the high thermal conductivity materials may be tuned to a desirable level by varying its diamond content.

Moreover, the high thermal conductivity substrate 102', the base plate 102, the fins 110, and/or the cold plate 100 in some embodiments may have a coefficient of thermal expansion (CTE) that is less than three times the CTE of silicon (Si). In particular, the high thermal conductivity substrate 102', the base plate 102, the fins 110, and/or cold plate 100 may have a CTE-to-Si value of less than about 200%, less than about 100%, less than about 70%, or less than about 50%, where the CTE-2-Si is calculated using the following formula: $CTE - 2 - Si = \left({CTE}_{SBF}-{CTE}_{Si}\right) / {CTE}_{Si}$ where CTE_{SBF} corresponds to the CTE of the high thermal conductivity material (e.g., the high thermal conductivity substrate 102', the base plate 102, or the fins 110) being compared to silicon, and CTE_{Si} corresponds to the CTE of silicon.

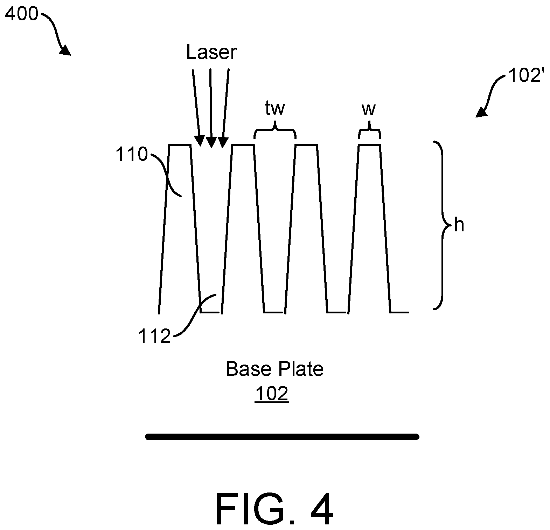

Referring now to FIG. 4, aspects of a method 400 for forming the cold plate 100 via laser ablation are depicted. In particular, the method 400 may be implemented per the method 300A of FIG. 3A. In particular, the laser ablation process of FIG. 4 may include providing a high thermal conductivity substrate 102' at 310A. In particular, the high thermal conductivity substrate 102' may comprise diamond, may comprise a diamond-SiC or diamond-SiC-Si composite material such as one of the above-noted grades of Thermadite^{™}, may comprise a copper diamond composite, or may comprise one or more of the other above-noted high thermal conductivity materials.

At 320A, the laser ablation process may further include forming fins 110 by removing material from the high thermal conductivity substrate 102' provided at 310A. In particular, a laser may form a series of cooling channels, cavities, or trenches 112 in an upper surface of the high thermal conductivity substrate 102' by ablating such material away from the high thermal conductivity substrate 102'. In some embodiments, the laser may form such cooling trenches 112 such that the cooling trenches 112 are linear and/or run generally parallel to one another and form fins 110 that extend upwardly between adjacent cooling trenches 112. Due to the nature of the laser ablation process, the cooling trenches 112 may taper such that each cooling trench 112 is wider at its upper opening than at its trench bottom. To address or reduce such tapering, the laser ablation of each cooling trench 112 may be performed at 2, 3, 4, 5, or more angles with respect to normal so as to widen the trench bottom, reduce the taper, and/or increase the depth of each cooling trench 112 and thus the height *h* of each fin 110.

In some embodiments, laser ablation at a single angle (*e.g*., normal to the upper surface of the high thermal conductivity substrate 102') may result in cooling trenches 112 with a width *tw* of about 100 µm at the trench opening. With a taper of about 4°, such cooling trenches 112 may reach a depth of about 570 µm. In embodiments, in which laser ablation is applied at multiple angles, the taper may be reduced and the depth increased to about 800 µm.

In various embodiments, the removal process at 320A may utilize a dry laser ablation process without the aid of a liquid etchant or a wet laser ablation process which is aided by a liquid etchant. In particular, such a wet laser ablation process may be referred to as a liquid phase high-energy-beam aided deep chemical etching process. Moreover, such wet laser ablation processes may be conducted using various liquid etchants such as oxidizing etchants (*e.g*., water, salt dissolved in liquid, or other oxygen-containing etchants), leaching etchants (*e.g*., halogen-containing etchants), and/or reducing etchants (*e.g*., salt dissolved in liquid, or hydrogen-containing etchants). Similarly, such wet laser ablation processes may be conducted using various laser sources such as infrared to EUV lasers, 1 W to multiple kW lasers, continuous lasers, modulated lasers, ion beams, plasma beams, electron beams, and/or high energy radiation.

In various embodiments, other processes may be used at 320A to remove remove material and form fins 110 between respective trenches 112. For example, chemical etching under high-energy radiation may be employed. In particular, inductive coupled plasma, ion beams, discharge plasma, and/or other high-energy radiation processes may be employed along with chemically-reactive chemicals or radicals to form trenches 112 and associated fins 110.

Results of a few test runs using a 532 nm laser at 58 watts and 8 kHz modulation and a water etchant to ablate a diamond-SiC-Si composite (*e.g*., Thermadite^{™}) substrate 102' are presented below in Table 2.

**Table 2**

| Test | Laser Passes | Trench Depth (µm) | Trench Width (µm) | Fin Width (µm) | Trench Aspect Ratio | Fin Aspect Ratio | Center-To-Center Fin Spacing (µm) |
|---|---|---|---|---|---|---|---|
| 1 | 16 | 838 | 63 | 140 | 13.3 | 6.0 | 200 |
| 2 | 16 | 827 | 63 | 96 | 13.1 | 8.7 | 160 |
| 3 | 32 | 1,565 | 64 | 99 | 24.5 | 15.8 | 160 |

From Table 2, cooling trench depths of greater than about 800 µm, of greater than about 1000, and about 1500 µm are achievable. Moreover, such depths are essentially linear with the number of passes of the laser in that doubling the number of passes effectively doubles the depth and aspect ratios of the cooling trenches 112 and fins 110.

Results of a few test runs of a dry ablating process using a laser at 12.5 watts to ablate a diamond substrate 102' are presented below in Table 3.

**Table 3**

| Test | Laser Passes | Gap Width (µm) | Fin Width (µm) | Gap Depth (µm) | Sidewall Taper (degrees) | Aspect Ratio |
|---|---|---|---|---|---|---|
| 1 | 5000 | 78.1 | 31.9 | 624.0 | 5.9 | 8.0 |
| 2 | 6000 | 77.7 | 31.4 | 650.6 | 5.3 | 8.4 |
| 3 | 7000 | 81.0 | 29.7 | 728.5 | 5.9 | 9.0 |
| 4 | 8000 | 79.6 | 31.6 | 761.2 | 6.1 | 9.6 |

From Table 3, cooling trench widths *tw* of greater than 70 µm, greater than about 75 µm, and greater than about 80 µm are achievable. Moreover, such cooling trench depths h of greater than about 600 µm, greater than about 700 µm, and greater than about 750 µm are achievable.

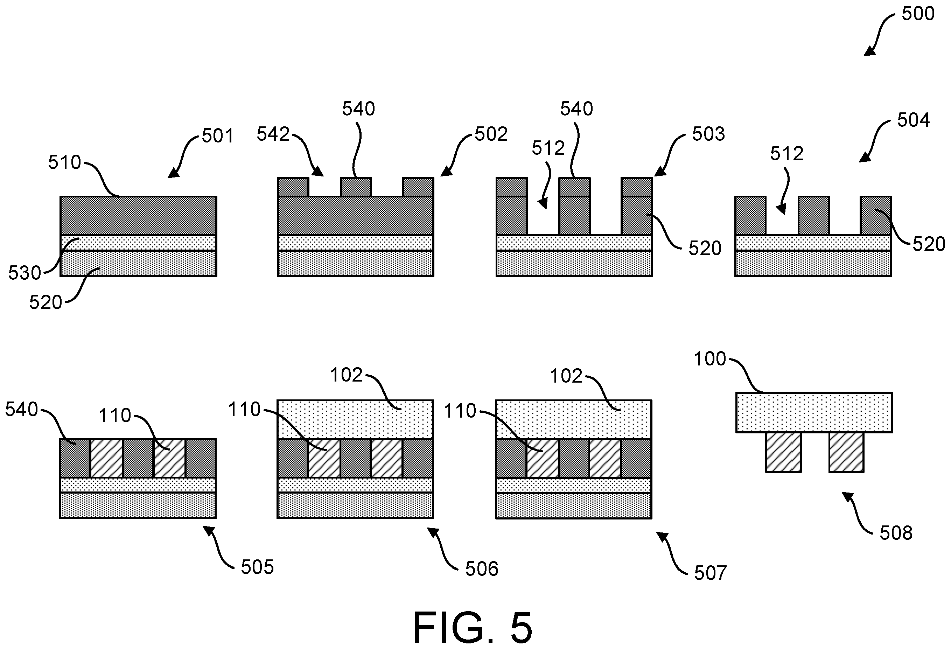

Referring now to FIG. 5, a method 500 of manufacturing the cold plate of FIG. 1 is shown. In general, the method 500 may include forming fins 110 and then forming or otherwise providing a base plate 102 on the fins 110 in a manner similar to method 300C of FIG. 3C. In particular, the method 500 may mold cast a diamond-SiC or diamond-SiC-Si composite to form the fins 110 and then the base plate 102.

To this end, the method 500 may begin at 501 with a substrate 510 of silicon, glass, or some other etchable material. In particular, a bottom side of the substrate 510 is coupled to a carrier or handle 520 via an etch stop layer 530. Then at 502, the method 500 may include at 502 forming a mask pattern 540 over a top side of the substrate 510. The mask pattern 540 may be formed to include openings 542 that are arranged in rows and columns and that correspond to a desired fin arrangement for the fins 110 of the cold plate 100.

The method 500 at 503 may include etching portions of the substrate 510 that are exposed by the openings 542 of the mask pattern 540. In particular, the etching may remove exposed portions of the substrate 510 down to the etch stop layer 530, thereby forming channels 512 in the substrate 510.

After such etching, the method 500 at 504 may include removing the mask pattern 540 from the top side of the substrate 510. Such removal may be accomplished via stripping, etching, and/or some other process.

The method 500 at 505 may fill the channels 512 with a high thermal conductivity material such as a diamond-SiC or diamond-SiC-Si composite. In this manner, the fins 110 of the cold plate 100 may be mold cast. At this point, the method 500, in some embodiments, may pyrolyze or otherwise cure the fins 110 prior to formation of the base plate 102. Regardless of whether the fins 110 are separately pyrolyzed or cured, the method 500 at 506 may form the base plate 102 over the cast fins 110. In particular, the method 500 may include casting or otherwise providing a high thermal conductivity material such as a diamond-SiC or diamond-SiC-Si composite material over the cast fins 110. In some embodiments, the method 500 uses the same high thermal conductivity material for the base plate 102 and the fins 110. In other embodiments, the method 500 uses different high thermal conductivity materials for the base plate 102 and the fins 110.

At 507, the method 500 may include pyrolyzing and/or curing the base plate 102 and the fins 110. Such pyrolyzing and/or curing may aid in joining and/or otherwise affixing the fins 110 to the base plate 102. Finally, at 508, the method 500 may remove the cast cold plate 100 (*i.e.,* the base plate 102 and the fins 110) from the mold comprising the substrate 510, the handle 520, and etch stop layer 530.

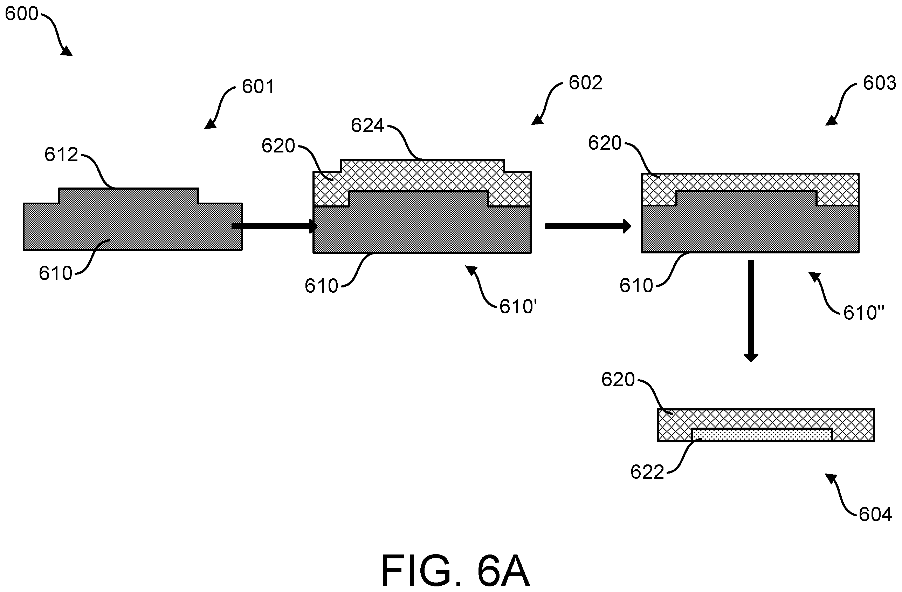

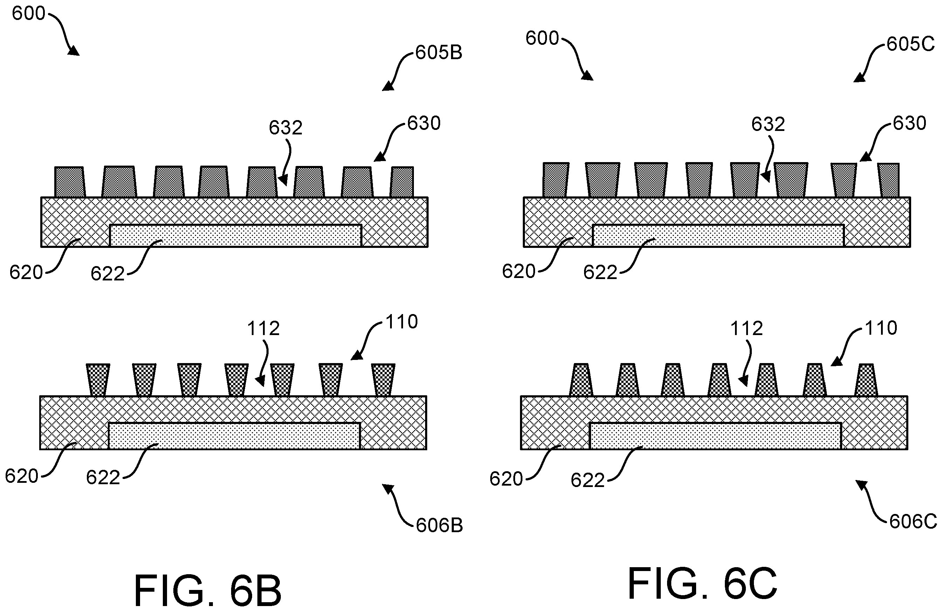

Referring now to FIGS. 6A and 6B, a method 600 of manufacturing the cold plate of FIG. 1 is shown. In general, the method 600 may include forming or otherwise providing a base plate 102 of diamond and casting, forming, and/or otherwise providing fins 110 on the diamond base plate 102 in a manner similar to method 300B of FIG. 3B.

To this end, the method 600 at 601 may provide or otherwise prepare a substrate 610 such as a silicon substrate that includes an O-ring protrusion 612. In particular, the O-ring protrusion 612 may be centrally positioned along the top side of the substrate 610 and may upwardly extend from the top side of the substrate 610. The O-ring protrusion 612 may have various lateral cross sections such as rectangular, square, circular, or elliptical.

At 602, the method 600 may include growing a conformal diamond layer 620 over the top surface of the substrate 610. Due to O-ring protrusion 612 of the substrate 610 and the conformal growth of the diamond layer 620, the grown diamond layer 620 at 602 may include an O-ring recess 622 in a bottom side of the diamond layer 620 as well as an O-ring protrusion 624 extending upwardly from the top side of the diamond layer 620.

In some embodiments, the diamond covered substrate 610' shown at 602 may be used as a base plate 102 in steps 605B, 606B of FIG. 6B or in steps 605C, 606C of FIG. 6C. However, in other embodiments, the O-ring protrusion 624 may be removed or reduced before proceeding to steps 605B, 606B of FIG. 6B or to steps 605C, 606C of FIG. 6C. In such embodiments, the method 600 may include at 603 laser lapping and/or other processes that polish the top side of the grown diamond layer 620. Such lapping may room the O-ring protrusion 624 so as to obtain a planar top side as shown at 603. However, in some embodiments, portions of the O-ring protrusion 624 may be removed while other portions are left behind. Such remnants of the O-ring protrusion 624 may aid in subsequently affixing of the fins 110 to the top side of the diamond layer 620 per the process shown in FIGS. 6B and 6C.

In some embodiments, the diamond covered substrate 610" shown at 603 may be used as a base plate 102 in steps 605B, 606B of FIG. 6B or in steps 605C, 606C of FIG. 6C. However, in other embodiments, the substrate 610 may be removed and the O-ring recess 622 exposed before proceeding to steps 605B, 606B of FIG. 6B or to steps 605C, 606C of FIG. 6C. In such embodiments, the method 600 at 604 may remove the substrate 610. In particular, the method 600 at 604 may use stripping, etching, laser ablation, and/or other processes to remove the substrate 610 from the diamond layer 620.

As shown FIGS. 6A and 6B, the diamond layer 620 may provide the base plate 102 of the cold plate 100 and fins 110 may be formed or otherwise provided on the top side of the diamond layer 620 or base plate 102. Such fins 110 may be provided in a similar manner as the fins 110 of FIG. 5. Namely, the method 600 may include providing a mold template 630 over the top side of the diamond layer 620 at 605B, 605C and filling the trenches or openings in the mold template 630 with high thermal conductivity material so as to form fins 110 attached to the top side of the diamond layer 620.

More specifically, at 605B, 605C, the method 600 may couple a substrate of silicon, glass, or some other etchable material to the top side of the diamond layer 620, and form a mask pattern over a top side of the substrate. The method 600 may further etch portions of the substrate that are exposed by the openings of the mask pattern so as to from the mold template 630 with channels 632, and may also remove the mask pattern from the top side of the mold template 630. As shown in FIG. 6B, such process may result in channels 632 which taper toward the diamond layer 620. Alternatively, such process may result in channels 632 which taper away from the diamond layer 620 as shown in FIG. 6C.

After providing the mold template 630 over the diamond layer 620, the method 600 at 606B, 606C may fill the channels 632 with a high thermal conductivity material such as a diamond-SiC or diamond-SiC-Si composite. In this manner, the fins 110 of the cold plate 100 may be mold cast. After forming the fins 110, the method 600 may remove the mold template 630 from the diamond layer 620 so as to arrive at the cold plate 100 shown at 606B, 606C.

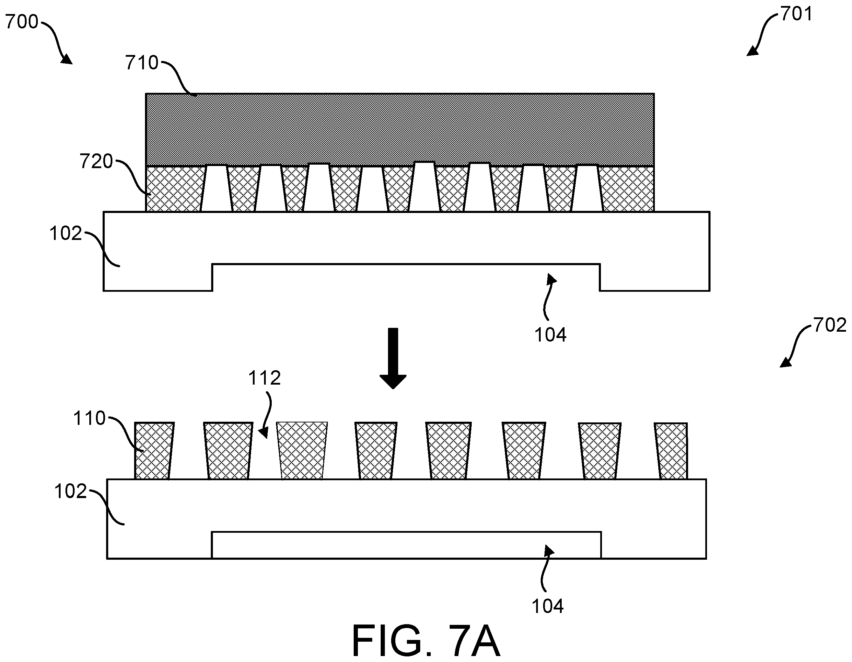

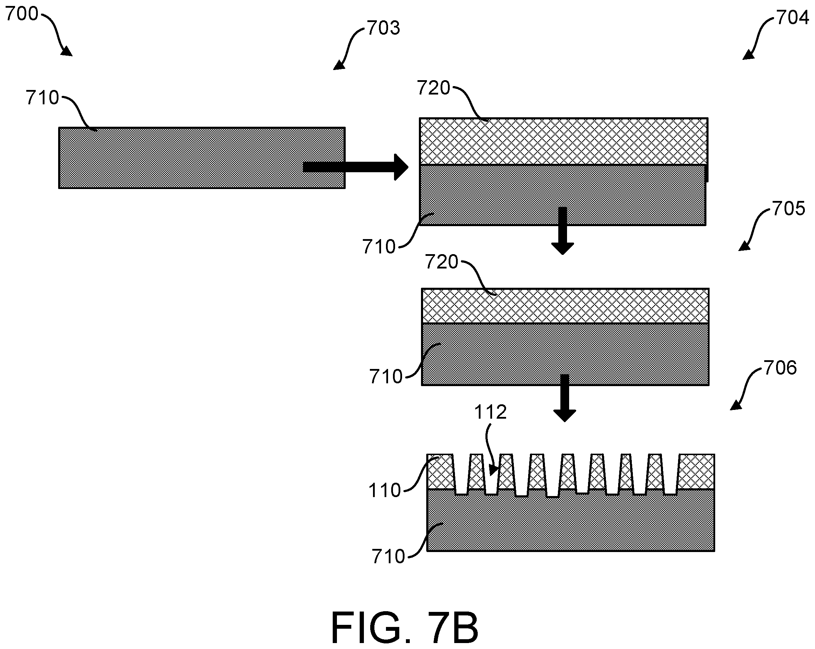

Referring now to FIGS. 7A and 7B, a method 700 of manufacturing the cold plate 100 of FIG. 1 is shown. In general, the method 700 may include forming or otherwise providing a base plate 102 of a diamond-SiC or diamond-SiC-Si composite and/or one or more of the other above-noted high thermal conductivity materials and may include providing or otherwise attaching diamond fins 110 to the base plate 102 in a manner similar to method 300B of FIG. 3B.

To this end, the method 700 at 701 may include providing or otherwise attaching diamond fins 110 to a top side of a provided base plate 102. While shown with an O-ring recess 104 in a bottom side of the base plate 102, the base plate 102 in some embodiments may lack an O-ring recess. Moreover, as shown, the diamond fins 110 may be provided or otherwise formed on a carrier substrate 710 and then provided to the base plate 102 as a group. As such, the method at 702 may include removing the substrate 710 from a top side of each diamond fin 110 once a bottom side of each diamond fin 110 is affixed to the base plate 102. Such removal may be via stripping, etching, and/or other processes.

Details regarding formation of the diamond fins 110 on the carrier substrate 710 are shown in FIG. 7B. As shown, the method 700 may include providing a carrier substrate 710 at 703. The carrier substrate 710 may comprise a semiconductor such as silicon and/or another material upon which diamond may be grown.

At 704, the method 700 may include growing a diamond layer 720 on a top side of the carrier substrate 710. Then, the method 700, in some embodiments, may include lapping and/or otherwise polishing the top side of the grown diamond layer 720 at 705. Such polishing may aid in subsequent laser cutting and/or laser ablation of the diamond layer 720. Such polishing may also aid in subsequent attachment of the formed diamond fins 110 to the base plate 102.

At 706, the method 700 may include forming cooling channels or trenches 112 in the diamond layer 720. Such cooling channels or trenches 112 may separate adjacent diamond fins 110. To this end, the method 700 may include laser cutting, laser ablation, etching, and/or other processes which remove diamond material from the diamond layer 720 and form cooling channels or trenches 112 into the top side of the diamond layer 720, thus forming diamond fins 110 separated by cooling channels or trenches 112.

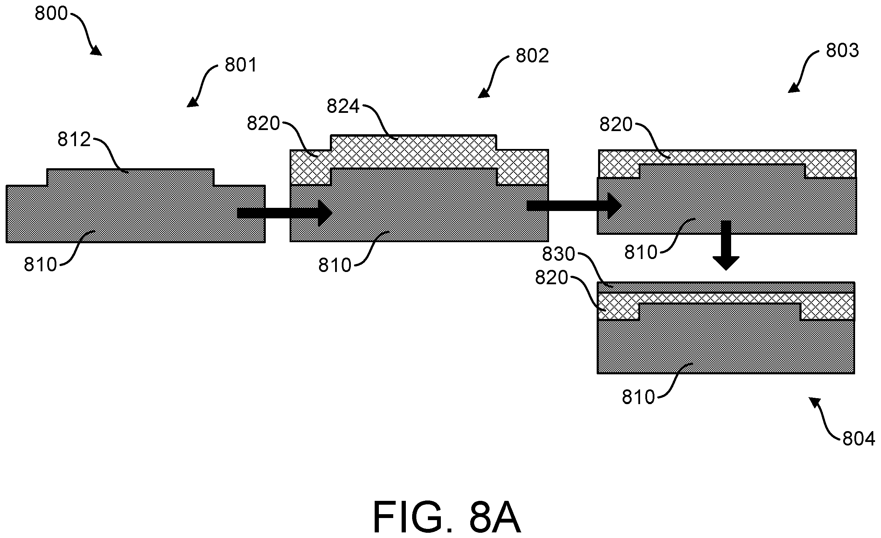

Referring now to FIGS. 8A-8C, a method 800 of manufacturing the cold plate of FIG. 1 is shown. In general, the method 800 may include forming or otherwise providing a base plate 102 of diamond and may include providing or otherwise attaching diamond fins 110 to the base plate 102 in a manner similar to method 300B of FIG. 3B. More specifically, the method 800 may include providing a diamond base plate 102 in a manner similar to the process shown in FIG. 6A, but with a further thin silicon film added to a top side of the diamond base plate 102. Furthermore, the method 800 may include providing diamond fins 110 in a manner similar to the process shown in FIG. 7B, but with the addition of a thin silicon film added to the diamond fins 110.

To this end, the method 800 at 801 may provide or otherwise prepare a substrate 810 such as a silicon substrate that includes an O-ring protrusion 812. In particular, the O-ring protrusion 812 may be centrally positioned along the top side of the substrate 810 and may upwardly extend from the top side of the substrate 810. The O-ring protrusion 812 may have various lateral cross sections such as rectangular, square, circular, or elliptical.

At 802, the method 800 may include growing a conformal diamond layer 820 over the top surface of the substrate 810. Due to the O-ring protrusion 812 of the substrate 810 and the conformal growth of the diamond layer 820, the grown diamond layer 820 at 802 may include an O-ring recess 822 in a bottom side of the diamond layer 820 as well as an O-ring protrusion 824 extending upwardly from the top side of the diamond layer 820.

At 803, the method 800 may include removing the O-ring protrusion 824 before proceeding to 804. In particular, the method 800 may include laser lapping and/or other processes that polish the top side of the grown diamond layer 820. Such lapping may remove the O-ring protrusion 824 so as to obtain a planar top side as shown at 803.

Then at 804, the method 800 may include providing a top side of the diamond layer 820 with a thin silicon layer 830. In particular, the method 800 may use spin coating, chemical vapor deposition, and/or other processes to form a thin silicon layer 830 over the diamond layer 820.

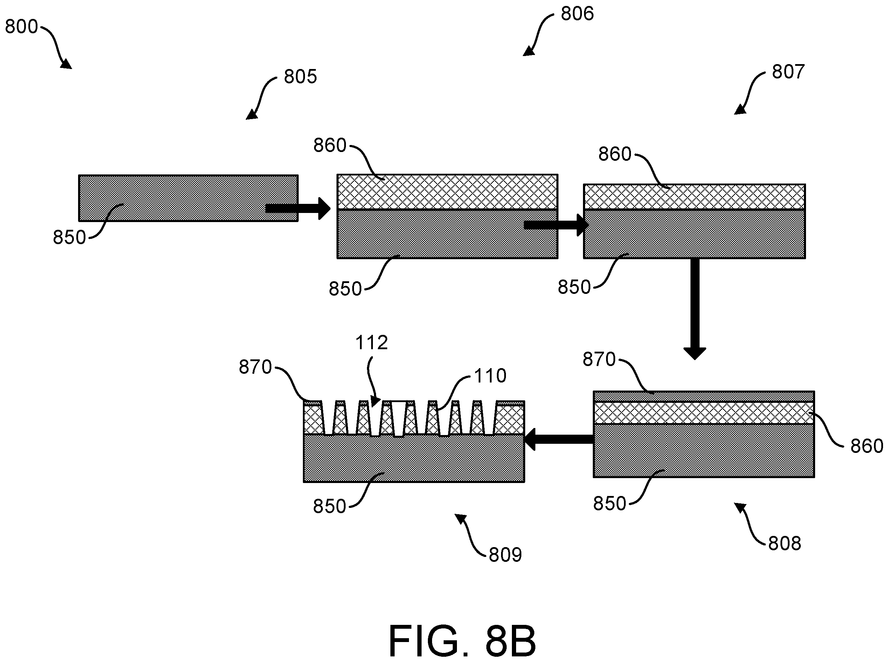

Referring now to FIG. 8B, details regarding formation of the diamond fins 110 are shown. In particular, the method 800 at 805 may include providing a carrier substrate 850. The carrier substrate 850 may comprise a semiconductor such as silicon and/or another material upon which diamond may be grown.

At 806, the method 800 may include growing a diamond layer 860 on a top side of the carrier substrate 850. Then, the method 800, in some embodiments, may include lapping and/or otherwise polishing the top side of the grown diamond layer 860 at 807. After such lapping, the method 800 at 808 may include providing a top side of the diamond layer 860 with a thin silicon layer 870. In particular, the method 800 may use spin coating, chemical vapor deposition, and/or other processes to form the thin silicon layer 870 over the diamond layer 860.

At 809, the method may include forming cooling channels or trenches 112 in the diamond layer 860. Such cooling channels or trenches 112 may separate adjacent diamond fins 110. To this end, the method 800 may include using laser cutting, laser ablation, etching, and/or other processes which remove diamond material from the diamond layer 860. Such removal of diamond material may form cooling channels or trenches 112 into the top side of the diamond layer 860, which may form diamond fins 110 that are separated by the cooling channels or trenches 112.

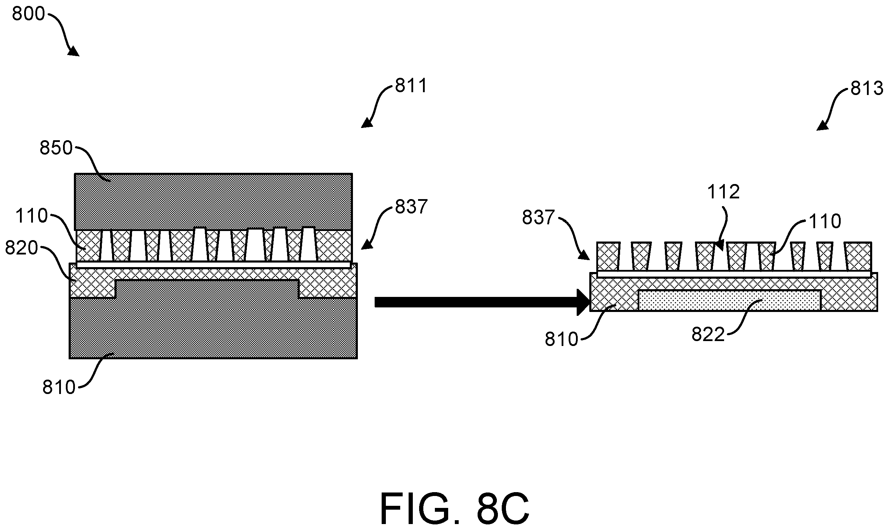

Referring now to FIG. 8C, the method 800 at 811 may include providing the diamond fins 110 on the diamond base plate 102. In particular, the carrier substrate 850 may be positioned over the top side of the diamond base plate 102 with a graphite adhesive between the thin silicon film 870 covering the diamond fins 110 and the thin silicon layer 830 covering the top side of the diamond base plate 102. Moreover, the method 800 may include anneal bonding by carbonization to form a silicon carbide interface 837 that bonds the diamond fins 110 to the diamond base plate 102.

Finally, after such bonding, the method 800 at 813 may include removing the substrate 810 from the base plate 102. In particular, the method 800 may use stripping, etching, laser ablation, and/or other processes to remove the substrate 810 from the diamond base 102.

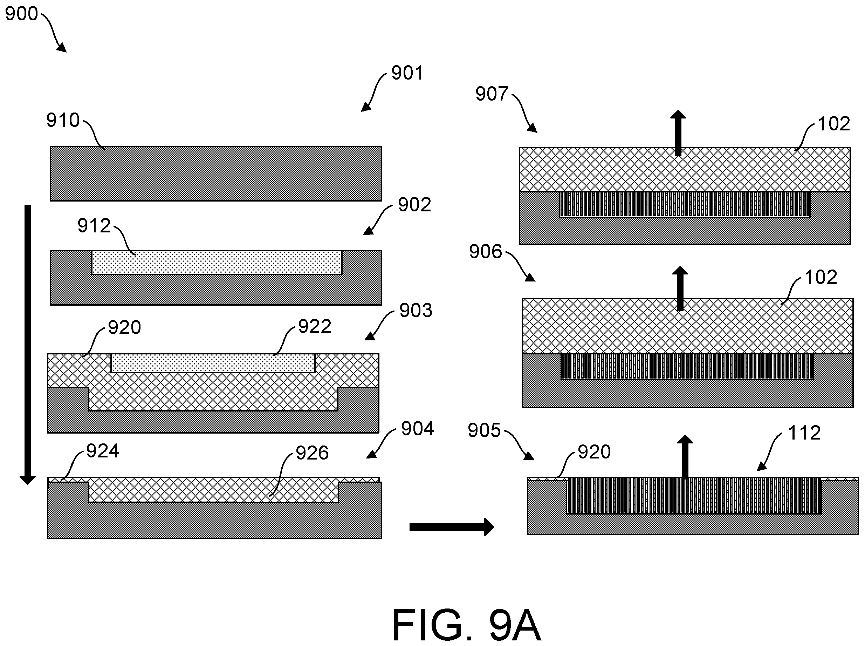

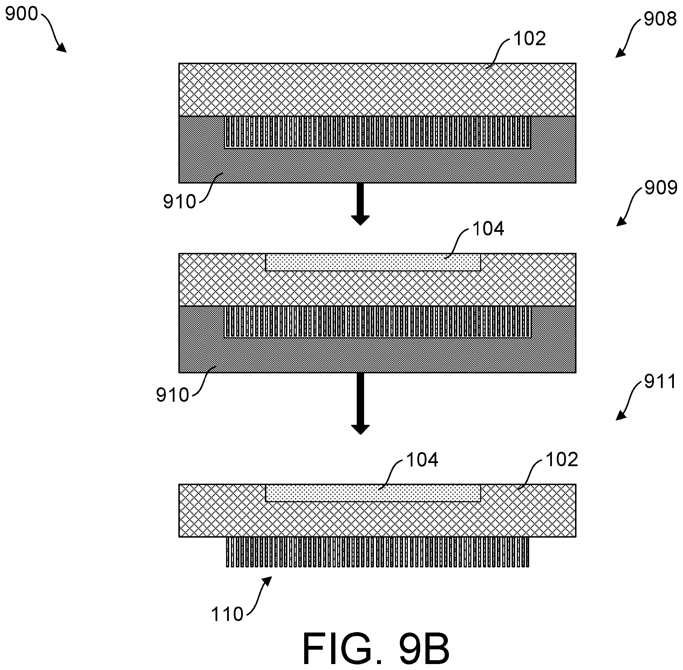

Referring now to FIGS. 9A and 9B, a method 900 of manufacturing the cold plate of FIG. 1 is shown. In general, the method 900 may include forming and/or otherwise providing diamond fins 110 and then providing a diamond base plate 102 over the diamond fins 110 in a manner similar to the method 300C of FIG. 3C.

To this end, the method 900 at 901 may include providing a substrate 910 such as a silicon or other substrate suitable for growing diamond. The method 900 at 902 may include forming a cavity 912 in a top side of the substrate 901. To this end, the method 900 may use etching, laser ablation, and/or other processes to remove material from the substrate 910 and form the cavity 912. Moreover, the method 900 may form the cavity 912 such that the cavity 912 has a depth that is greater than the diamond layer 920 and fins 110 to be subsequently formed.

At 903, the method 900 may include growing a diamond layer 920 over the top side of substrate 910. In particular, the method 900 may grow the diamond layer 920 such that the diamond layer 920 conforms to the top side of the substrate 901 and to a thickness or depth that is less than the depth of the cavity 912. As a result, the diamond layer 920 may cover a perimeter of the substrate 910 and the cavity 912 in the substrate 910 resulting in a cavity 922 in the top side of the diamond layer 920.

At 904, the method 900 may include polishing, lapping, and/or otherwise planarizing the top side of the diamond layer 920. Through such diamond lapping, the top side of the diamond layer 920 is polished flat. However, the polishing, lapping, and/or otherwise planarizing of the top side of the diamond layer 920 is stopped prior to reaching the top side of the substrate 910. In this manner, a perimeter or rim portion 924 of the diamond layer 920 that encircles the cavity portion 926 of the diamond layer 920 is retained.

At 905, the method 900 may include forming cooling channels or trenches 112 into the top side of the diamond layer 920. In particular, the method 900 may include laser cutting, laser ablation, etching, and/or some other processes that cut into the top side of the diamond layer 920 to form diamond fins 110 between the cooling channels or trenches 112. After forming the diamond fins 110, the method 900 at 906 may include growing a diamond base plate 102 over the diamond fins 110.

At 907 and 908, the method 900 may include optionally reducing the thickness of the diamond base plate 102 to a desired thickness and/or polishing the top side of the diamond base plate 102 through laser lapping, etching, and/or other processes. Then, at 909, the method 900 may include forming an O-ring recess 124 into the base plate 102. Finally, at 911, the method 900 may remove the substrate 901 from the formed cold plate 100 using stripping, etching, and/or other processes.

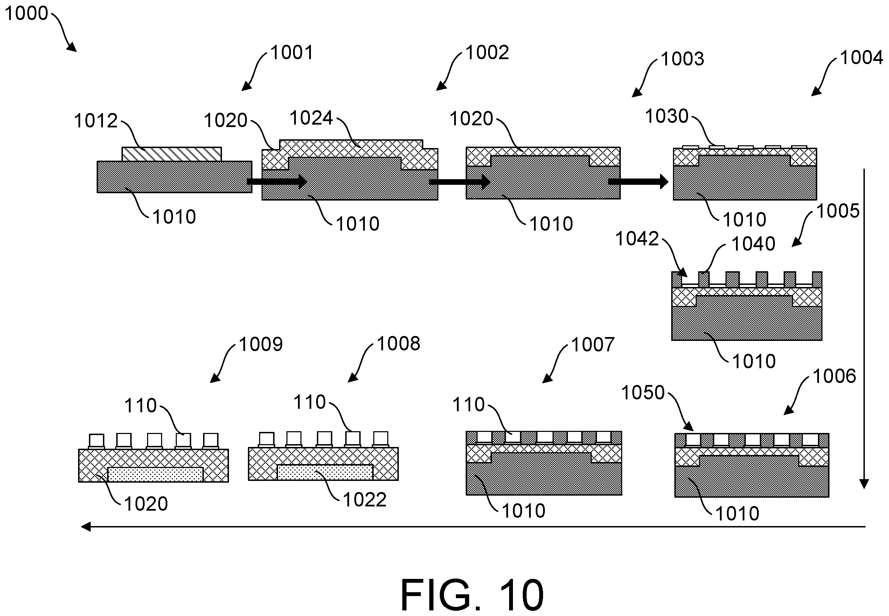

Referring now to FIG. 10, a method 1000 of manufacturing the cold plate of FIG. 1 is shown. In general, the method 1000 may include forming and/or otherwise providing a diamond base plate 102 and then forming and/or otherwise providing copper fins or copper diamond fins 110 on the diamond base plate 102 in a manner similar to the method 300B of FIG. 3B.

To this end, the method 1000 at 1001-1004, may include providing a diamond base plate 102 in a manner similar to the process shown in FIG. 6A, but with a further thin metal (*e.g.,* aluminum or copper) film added to a top side of the diamond base plate 102. In particular, the method 1000 at 1001 may provide or otherwise prepare a substrate 1010 such as a silicon substrate that includes an O-ring protrusion 1012. In particular, the O-ring protrusion 1012 may be centrally positioned along the top side of the substrate 1010 and may upwardly extend from the top side of the substrate 1010. The O-ring protrusion 1012 may have various lateral cross sections such as rectangular, square, circular, or elliptical.

At 1002, the method 1000 may include growing a conformal diamond layer 1020 over the top surface of the substrate 1010. Due to the O-ring protrusion 1012 of the substrate 1010 and the conformal growth of the diamond layer 1020, the grown diamond layer 1020 at 1002 may include an O-ring recess 1022 in a bottom side of the diamond layer 1020 as well as an O-ring protrusion 1024 extending upwardly from the top side of the diamond layer 1020.

At 1003, the method 1000 may include removing the O-ring protrusion 1024 before proceeding to 1004. In particular, the method 1000 may include laser lapping and/or other processes that polish the top side of the grown diamond layer 1020. Such lapping may remove the O-ring protrusion 1024 so as to obtain a planar top side as shown at 1003.

Then at 1004, the method 1000 may include providing a top side of the diamond layer 1020 with a thin metal layer 1030. In particular, the method 1000 may use spin coating, chemical vapor deposition, and/or other processes to form the thin metal layer 1030 over the diamond layer 1020.

The method 1000 at 1004 may include providing a mold template 1040 over the top side of the diamond layer 1020. To this end, the method 1000 may couple a substrate of silicon, glass, or some other etchable material to the top side of the diamond layer 1020, and form a mask pattern over a top side of the substrate. The method 1000 may further etch portions of the substrate that are exposed by the openings of the mask pattern so as to from the mold template 1040 with channels 1042, and may also remove the mask pattern from the top side of the mold template 1040.

After providing the mold template 1040 over the diamond layer 1020, the method 1000 at 1006 and 1007 may include filling the channels 1042 with thermal conductivity materials 1050 such as copper or copper diamond. In particular, the method 1000 at 1006 may fill the channels 1042 with copper or copper diamond powders and at 1007 may electroplate the copper or copper diamond powders by applying an electrical current to the thin metal layer 1030. After forming the fins 110, the method 1000 at 1008 may include removing the mold template 1040 and the substrate 1010 from the diamond layer 1020. Moreover, the method 1000 at 1009 may laser trim, singulate, and/or otherwise cut the cold plate 100 to a desired shape.

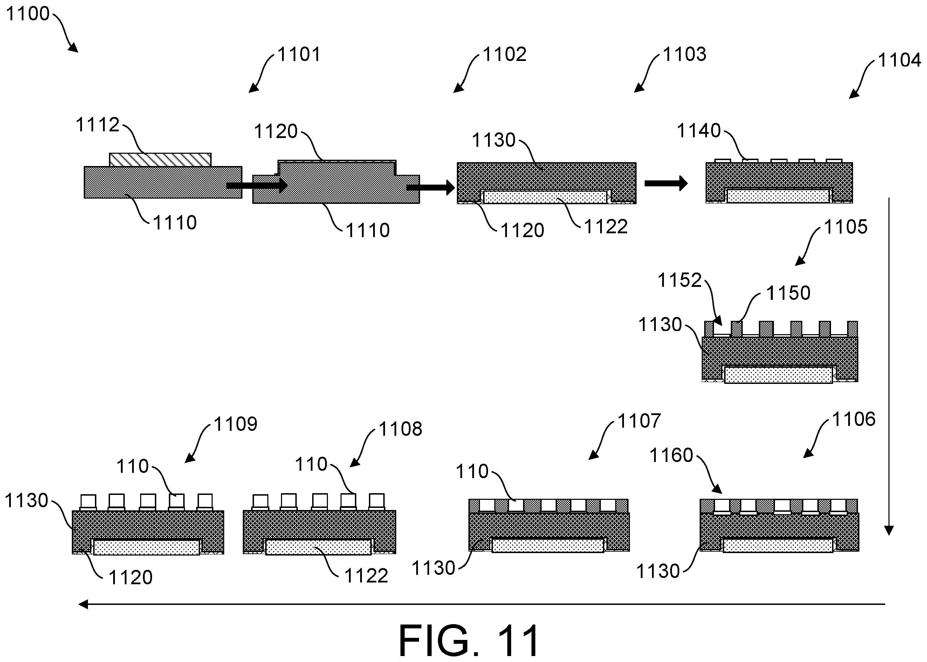

Referring now to FIG. 11, a method 1100 of manufacturing the cold plate of FIG. 1 is shown. In general, the method 1100 may include forming and/or otherwise providing a diamond-SiC or diamond-SiC-Si composite base plate 102 and then forming and/or otherwise providing copper fins or copper diamond fins 110 on the diamond-SiC or diamond-SiC-Si base plate 102 in a manner similar to the method 300B of FIG. 3B.

To this end, the method 1100 at 1101-1104 may include providing a diamond-SiC or diamond-SiC-Si base plate 102 with an optional thin diamond layer along a bottom side of the base plate 102 and a thin metal (*e.g.,* aluminum or copper) film along a top side of the base plate 102. In particular, the method 1100 at 1101 may provide or otherwise prepare a substrate 1110 such as a silicon substrate that includes an O-ring protrusion 1112. In particular, the O-ring protrusion 1112 may be centrally positioned along the top side of the substrate 1110 and may upwardly extend from the top side of the substrate 1110. The O-ring protrusion 1112 may have various lateral cross sections such as rectangular, square, circular, or elliptical.

At 1102, the method 1000 may include growing a thin conformal diamond layer 1120 over the top surface of the substrate 1110. Due to the O-ring protrusion 1112 of the substrate 1110 and the conformal growth of the diamond layer 1120, the grown diamond layer 1120 at 1102 may include an O-ring recess 1122 in a bottom side of the diamond layer 1120 as well as an O-ring protrusion 1124 extending upwardly from the top side of the diamond layer 1120.

At 1103, the method 1100 may include casting or otherwise forming a diamond-SiC or diamond-SiC-Si composite layer 1130 over the diamond layer 1120 and optionally removing the substrate 1110. Then at 1104, the method 1000 may include providing a top side of the diamond-SiC or diamond-SiC-Si composite layer 1130 with a thin metal layer 1140. In particular, the method 1100 may use spin coating, chemical vapor deposition, and/or other processes to form the thin metal layer 1140 over the diamond-SiC or diamond-SiC-Si composite layer 1130. In this manner, the method 1100 may obtain the diamond-SiC or diamond-SiC-Si composite base plate 102 that includes a thin metal layer 1140 along its top side and a thin diamond layer 1120 that lines an O-ring cavity 1122 in the bottom side of the base plate 102.

The method 1100 at 1105 may include providing a mold template 1150 over the top side of the base plate 102. To this end, the method 1100 may couple a substrate of silicon, glass, or some other etchable material to the top side of the base plate 102, and form a mask pattern over a top side of the substrate. The method 1100 may further etch portions of the substrate that are exposed by the openings of the mask pattern so as to from the mold template 1150 with channels 1152, and may also remove the mask pattern from the top side of the mold template 1150.

After providing the mold template 1150 over the base plate 102, the method 1100 at 1106 and 1107 may include filling the channels 1152 with thermal conductivity materials 1160 such as copper or copper diamond. In particular, the method 1100 at 1106 may fill the channels 1152 with copper or copper diamond powders and at 1107 may electroplate the copper or copper diamond powders by applying an electrical current to the thin metal layer 1140. After forming the fins 110, the method 1100 at 1108 may include removing the mold template 1150 from the base plate 102. Moreover, the method 1100 at 1109 may laser trim, singulate, and/or otherwise cut the cold plate 100 to a desired shape.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will include all examples falling within the scope of the appended claims.
Further aspects of the invention are described in the following clauses:
Clause 1. A cold plate comprising:
   a base plate comprising a top side, a bottom side, and lateral sides between the bottom side and the top side; and
   fins that protrude from the top side of the base plate; and
   wherein the base plate has a thermal conductivity greater than about 450 W/m-K.
Clause 2. The cold plate of clause 1, wherein the thermal conductivity of the fins is greater than about 450 W/m-K.
Clause 3. The cold plate of clause 1, wherein the base plate comprises a diamond-SiC or diamond-SiC-Si composite base plate.
Clause 4. The cold plate of clause 3, wherein each fin comprises a diamond-SiC or diamond-SiC-Si composite fin.
Clause 5. The cold plate of clause 3, wherein each fin comprises a diamond fin.
Clause 6. The cold plate of clause 3, wherein each fin comprises a copper fin.
Clause 7. The cold plate of clause 3, wherein each fin comprises a copper diamond fin.
Clause 8. The cold plate of clause 1, wherein the base plate comprises a diamond base plate.
Clause 9. The cold plate of clause 8, wherein each fin comprises a diamond-SiC or diamond-SiC-Si composite fin.
Clause 10. The cold plate of clause 8, wherein each fin comprises a diamond fin.
Clause 11. The cold plate of clause 8, wherein each fin comprises a copper fin.
Clause 12. The cold plate of clause 8, wherein each fin comprises a copper diamond fin.
Clause 13. The cold plate of clause 1, comprising an O-ring recess in the bottom side of the base plate.
Clause 14. The cold plate of clause 1, wherein base plate and/or fins comprise:
   a metallic matrix of copper (Cu), aluminum (Al), nickel (Ni), tungsten (W), molybdenum (Mo), titanium (Ti), tantalum (Ta), and/or chromium (Cr);
   a ceramic matrix of silicon carbide (SiC), tungsten carbide (WC), molybdenum carbide (MoC), and/or boron nitride (BN); or
   a semiconductor matrix of silicon (Si) and/or germanium (Ge).
Clause 15. The cold plate of clause 1, wherein base plate and/or fins comprise a single crystal, a polycrystalline, or a composite of diamond and/or boron nitride having interfaces of nitride and/or carbide species including silicon carbide (SiC), tungsten carbide (WC), molybdenum carbide (MoC), chromium carbide (CrC), zirconium carbide (ZrC), tantalum carbide (TaC), hafnium carbide (HfC), vanadium carbide (VC), niobium carbide (NbC), and/or germanium carbide (GeC).
Clause 16. A cooling system for a heat-generating device, comprising:
   the cold plate of clause 1 comprising a side configured to be mounted to the heat-generating device; and
   a fluid distribution system coupled to the cold plate.
Clause 17. The cooling system of clause 16, comprising:
   manifold bonded to the cold plate via brazing, soldering, an O-ring, and/or adhesion layer; and
   wherein the fluid distribution system comprises two or more fluid-carrying conduits coupled to the manifold.
Clause 18. The cooling system of clause 17, wherein the manifold comprises one or more metallic materials, ceramic materials, polymer materials, insulating materials, conductive materials, low thermal conductivity materials, a high thermal conductivity materials, aluminum, copper, stainless steel, nickel-cobalt ferrous alloy, tungsten, molybdenum, silicon, ceramics, glass, quartz, or nickel-iron alloy.
Clause 19. The cooling system of clause 17, wherein an absolute value of a coefficient of thermal expansion (CTE) difference between the manifold and the cold plate less than 25 ppm/m-K, less than 17 ppm/m-K, less than 10 ppm/m-K, less than 6 ppm/m-K, less than 4 ppm/m-K, or less than 2 ppm/m-K.
Clause 20. A method of forming a cold plate, the method comprising:
   providing a base plate of the cold plate; and
   providing fins of the cold plate;
   wherein the base plate has a thermal conductivity greater than about 450 W/m-K; and
   wherein the fins of the cold plate protrude from a top side of the base plate.
Clause 21. The method of clause 20, wherein providing the base plate comprises forming a diamond-SiC or diamond-SiC-Si composite layer over the fins.
Clause 22. The method of clause 20, wherein providing the base plate comprises forming a diamond layer over the fins.
Clause 23. The method of clause 20, wherein:
   providing the base plate of the cold plate comprises forming a diamond-SiC or diamond-SiC-Si base plate; and
   providing the fins of the cold plate comprises attaching diamond fins to a top side of the diamond-SiC or diamond-SiC-Si base plate.
Clause 24. The method of clause 20, wherein:
   providing the base plate of the cold plate comprises forming a diamond-SiC or diamond-SiC-Si base plate; and
   providing the fins of the cold plate comprises electroplating copper or copper diamond fins to a top side of the diamond-SiC or diamond-SiC-Si base plate.
Clause 25. The method of clause 20, wherein:
   providing the base plate of the cold plate comprises forming a diamond-SiC or diamond-SiC-Si base plate; and
   providing the fins of the cold plate comprising laser ablating trenches in a top side of the diamond-SiC or diamond-SiC-Si base plate to form diamond-SiC or diamond-SiC-Si fins.
Clause 26. The method of clause 20, wherein:
   providing the base plate of the cold plate comprises forming a diamond base plate; and
   providing the fins of the cold plate comprises attaching diamond fins to a top side of the diamond base plate.
Clause 27. The method of clause 20, wherein:
   providing the base plate of the cold plate comprises forming a diamond base plate; and
   providing the fins of the cold plate comprising copper or copper diamond fins to the top side of the diamond base plate.
Clause 28. The method of clause 20, wherein:
   providing the base plate of the cold plate comprises forming a diamond base plate; and
   providing the fins of the cold plate comprises laser ablating trenches in a top side of the diamond base plate to form diamond fins.
Clause 29. The method of clause 20, wherein providing the fins of the cold plate comprises mold casting fins on a top side of the base plate.
Clause 30. The method of clause 20, wherein providing the fins of the cold plate comprises providing diamond-SiC or diamond-SiC-Si composite fins on a top side of the base plate.

## Claims

1. A cold plate comprising:
a base plate comprising a top side, a bottom side, and lateral sides between the bottom side and the top side; and
fins that protrude from the top side of the base plate; and
wherein the base plate has a thermal conductivity greater than about 450 W/m-K.

2. The cold plate of claim 1, wherein the thermal conductivity of the fins is greater than about 450 W/m-K.

3. The cold plate of claim 1 or 2, wherein the base plate comprises a diamond-SiC or diamond-SiC-Si composite base plate and/or wherein each fin comprises a diamond-SiC or diamond-SiC-Si composite fin or a diamond fin or a copper fin or a copper diamond fin.

4. The cold plate of claim 1 or 2, wherein the base plate comprises a diamond base plate and/or wherein each fin comprises a diamond-SiC or diamond-SiC-Si composite fin or a diamond fin or a copper fin or a copper diamond fin.

5. The cold plate of any one of claims 1-4, comprising an O-ring recess in the bottom side of the base plate.

6. The cold plate of claim 1 or 2, wherein base plate and/or fins comprise:
a metallic matrix of copper (Cu), aluminum (Al), nickel (Ni), tungsten (W), molybdenum (Mo), titanium (Ti), tantalum (Ta), and/or chromium (Cr);
a ceramic matrix of silicon carbide (SiC), tungsten carbide (WC), molybdenum carbide (MoC), and/or boron nitride (BN); or
a semiconductor matrix of silicon (Si) and/or germanium (Ge).

7. The cold plate of claim 1 or 2, wherein base plate and/or fins comprise a single crystal, a polycrystalline, or a composite of diamond and/or boron nitride having interfaces of nitride and/or carbide species including silicon carbide (SiC), tungsten carbide (WC), molybdenum carbide (MoC), chromium carbide (CrC), zirconium carbide (ZrC), tantalum carbide (TaC), hafnium carbide (HfC), vanadium carbide (VC), niobium carbide (NbC), and/or germanium carbide (GeC).

8. A cooling system for a heat-generating device, comprising:
the cold plate of any one of claims 1-7 comprising a side configured to be mounted to the heat-generating device; and
a fluid distribution system coupled to the cold plate.

9. The cooling system of claim 8, comprising:
a manifold bonded to the cold plate via brazing, soldering, an O-ring, and/or adhesion layer; and
wherein the fluid distribution system comprises two or more fluid-carrying conduits coupled to the manifold;
wherein the manifold preferably comprises one or more metallic materials, ceramic materials, polymer materials, insulating materials, conductive materials, low thermal conductivity materials, a high thermal conductivity materials, aluminum, copper, stainless steel, nickel-cobalt ferrous alloy, tungsten, molybdenum, silicon, ceramics, glass, quartz, or nickel-iron alloy.

10. The cooling system of claim 9, wherein an absolute value of a coefficient of thermal expansion (CTE) difference between the manifold and the cold plate is less than 25 ppm/m-K, less than 17 ppm/m-K, less than 10 ppm/m-K, less than 6 ppm/m-K, less than 4 ppm/m-K, or less than 2 ppm/m-K.

11. A method of forming a cold plate, the method comprising:
providing a base plate of the cold plate; and
providing fins of the cold plate;
wherein the base plate has a thermal conductivity greater than about 450 W/m-K; and
wherein the fins of the cold plate protrude from a top side of the base plate.

12. The method of claim 11, wherein providing the base plate comprises forming a diamond-SiC or diamond-SiC-Si composite layer over the fins or forming a diamond layer over the fins.

13. The method of claim 11, wherein:
providing the base plate of the cold plate comprises forming a diamond-SiC or diamond-SiC-Si base plate; and
providing the fins of the cold plate comprises
attaching diamond fins to a top side of the diamond-SiC or diamond-SiC-Si base plate or
electroplating copper or copper diamond fins to a top side of the diamond-SiC or diamond-SiC-Si base plate or
laser ablating trenches in a top side of the diamond-SiC or diamond-SiC-Si base plate to form diamond-SiC or diamond-SiC-Si fins.

14. The method of claim 11, wherein:
providing the base plate of the cold plate comprises forming a diamond base plate; and
providing the fins of the cold plate comprises
attaching diamond fins to a top side of the diamond base plate or
electroplating copper or copper diamond fins to the top side of the diamond base plate or
laser ablating trenches in a top side of the diamond base plate to form diamond fins.

15. The method of claim 11, wherein providing the fins of the cold plate comprises mold casting fins on a top side of the base plate or providing diamond-SiC or diamond-SiC-Si composite fins on a top side of the base plate.
